# EUROPEAN PATENT SPECIFICATION

(11) **EP 3 232 511 B1**
(45) Date of publication and mention of the grant of the patent: **01.04.2020**
(21) Application number: 17305437.0
(22) Date of filing: 12.04.2017
(51) Int. Cl.: H01R 4/30, H05K 7/04, H05K 7/14, H05K 9/00

(54) **PLUGGABLE ELECTRICAL MODULE**
STECKBARES ELEKTRISCHES MODUL
MODULE ÉLECTRIQUE ENFICHABLE

(30) Priority: 15.04.2016 CN 201610236696
(43) Date of publication of application: 18.10.2017
(73) Proprietor: Schneider Electric Industries SAS, 92500 Rueil-Malmaison (FR)
(72) Inventor: XIA, Juan, Shanghai, 201203 (CN); SHENG, Xiangzuo, Shanghai, 201203 (CN); NI, Liang, Shanghai, 201203 (CN); CAI, Ningguo, Shanghai, 201203 (CN)
(74) Representative: Manitz Finsterwald Patent- und Rechtsanwaltspartnerschaft mbB

(56) References cited:
- EP-A1- 1 345 292
- JP-U- S61 169 964
- US-A- 5 218 518
- US-A- 5 966 289

## Description

### Technical field

The present invention relates to a pluggable electrical module. In particular, the present invention relates to a pluggable electrical module enabling reliable high-current discharge grounding in a simple manner.

### Prior art

Electrical systems often use modular design to increase flexibility. Electronic components belonging to a same module are usually mounted on a printed circuit board (PCB), which is then enclosed in a housing to form an electrical module. In order to reduce the manufacturing cost and weight of the electrical module, the housing of the electrical module is usually made of plastic material. Due to the insulating properties of plastic material, reliable high-current discharge grounding for the electrical module to be deployed in the electrical system needs to be specifically designed. Typically, high-current discharge grounding is achieved by a grounding cable connecting the electrical module to a chassis or rack.

To facilitate its installation and service, many electrical modules are designed to be pluggable, i.e. it can be inserted and fastened to the chassis in a simple manner, and released and pulled out of the chassis in a simple manner. For pluggable electrical modules, grounding by the use of grounding cable is cumbersome, and greatly reduces the convenience of plug operation. Furthermore, as people sometimes forget to connect the grounding cable due to careless, the electrical module is then at risk of being ungrounded. In order to avoid the use of cables, the existing design uses one or more metal elastic tab, and achieves the ground contact between the pluggable electrical module and the chassis through the elastic deformation of the elastic tabs. Due to manufacturing tolerances of the housing of the electrical module and the chassis, in addition to assembly tolerances during assembly and the elastic deformation of the assembled material, the deformation amount of the elastic tabs required to achieve the contact between the housing and the chassis can be found hard to determine. Therefore, the grounding using the metal elastic tabs is not reliable, and the grounding resistance often occur to be too large, thus cannot meet the requirement of high-current discharge grounding, even totally losing the grounding at worst scenario. If this happens, a considerable discharge current may flow through the electronic components on the PCB board, shortening the life of the electronic components, even burning the electronic components at severe times.

US5218518A1 describes a box-shaped module with PCB board housed therein. The box-shaped module is provided with ground clips for connection to a mounting rack. However, the connection is merely achieved through positioning the ground clips near threaded bolts of the mounting rack so as to form electrical contact. Therefore, the grounding of PCB board is also not reliable.

In summary, there many drawbacks exist in the existing pluggable electrical module, making high-current discharge grounding of the pluggable electrical module to be unreliable.

### Summary of the invention

Accordingly, it is an object of the present invention to provide a pluggable electrical module capable of achieving reliable high-current discharge grounding with a simple structure.

The object is achieved by a pluggable electrical module according to one embodiment of the present invention comprising: a printed circuit board; a housing for enclosing said printed circuit board therein, the housing comprising at least one housing through-hole; a captive screw having a screw head and a screw rod, the captive screw passing through the housing through-hole in the assembled configuration; a metal tab fixed to the printed circuit board and including an tab through-hole through which the captive screw can pass, in the assembled structure of the pluggable electrical module, the tab through-hole is coaxial with the housing through-hole. The screw rod of the captive screw includes at least a first thread segment and a second thread segment, the diameter of the second thread segment being larger than the first thread segment, and the second thread segment being closer to the screw head than the first thread segment. The captive screw is used to fasten the pluggable electrical module to a chassis. When the pluggable electrical module is fastened to the chassis, the first thread segment passes through the tab through-hole, while the second thread segment presses the metal tab tightly against the chassis, so that a reliable electrical connection with a contact resistance as small as possible is formed between the printed circuit board and the chassis. The housing through-hole includes a plurality of through-hole segments arranged along its longitudinal direction, wherein at least one of the through-hole segments is tapered in a direction away from the screw head. The inner diameter of the front end of the tapered through-hole is larger than the diameter of the first thread segment, but smaller than the diameter of the second thread segment. The inner diameter of the rear end of the tapered through-hole is larger than that of the second thread. When the second thread segment is screwed through the tapered through-hole, the thread of the second thread segment engages the inner wall of the tapered through-hole and forces the tapered through-hole to expand, acting similarly to a tapping screw. After the second thread segment completely passes through the tapered through-hole, the inner wall of the tapered through-hole is restored to its initial position under elastic action and restrains the second thread so that it cannot retreat, thereby preventing the captive screw from separating from the housing.

In a preferred embodiment, the number of through-hole segments is four.

In a further preferred embodiment, the screw rod of the captive screw further comprises a third rod segment provided between the second thread segment and the screw head, the diameter of the third rod segment being smaller than that of the second thread segment. In addition, the third rod segment can be threaded or not.

In an alternative embodiment, the pluggable electrical module further comprises a resilient washer. The inner diameter of the resilient washer is larger than the diameter of the first thread segment but smaller than the diameter of the second thread segment. When the pluggable electrical module is fastened to the chassis, the second threaded segment will press the resilient washer, which in turn presses a portion of the metal tab against outer surface of the housing. The tolerances of the electrical module and the chassis accumulated during manufacture and assemble process can be filled by the deformation capability of the resilient washer, thus ensuring a reliable high-current discharge grounding connection between the electrical module and the chassis in any case. In a further preferred embodiment, the resilient washer is a rubber O-ring. More preferably, the rubber O-ring includes two portions having the same inner diameter but different outer diameters, wherein one of the two portions having a smaller outer diameter is located at the rear of the rubber O-ring and can be fitted into the housing through-hole. This embedding effect prevents the rubber O-ring from falling off the housing through-hole.

In an alternative embodiment, the pluggable electrical module further comprises a spring for assisting the captive screw, the spring being nested between the second thread segment and the screw head of the captive screw. After the pluggable electrical module is fastened to the chassis, the spring can be compressed and pushed back against the captive screws to ensure tight engagement between the first thread segment of the captive screw and the threaded hole of the chassis, so as to prevent disengagement between this two.

In an alternative embodiment, the pluggable electrical module further comprises a colour identification ring nested between the second thread segment and the screw head of the captive screw. If a spring is provided, the colour identification ring is then located between the spring and the screw head. The longitudinal length of the colour identification ring is specifically designed. As a result, if the colour identification ring is still visible after the pluggable electrical module is fastened to the chassis, it means that the metal tab has not been pressed against the outer surface of the chassis tightly enough. On the other hand, if the colour identification ring has been fully pushed into the housing through-hole and cannot be seen externally, it means that the metal tab has been pressed tightly against the outer surface of the chassis. This makes it possible to confirm in a simple and intuitive manner whether a reliable high-current discharge grounding connection is formed between the electrical module and the chassis.

### Description of the drawings

In the following, the invention will be described in detail by way of example and with reference to the accompanying drawings, in which
Figure 1 is a schematic view of a PCB board with metal tab according to one embodiment of the present invention.
Figure 2 is a schematic view of the pluggable electrical module after assemble according to one embodiment of the present invention.
Figure 3a is a cross-sectional view of a pluggable electrical module according to one embodiment of the present invention.
Figures 3b-c are detailed cross-sectional views of a housing through-hole and captive screw according to one embodiment of the present invention.
Figure 4 is a schematic view of a pluggable electrical module mounted on a chassis in accordance with one embodiment of the present invention.

### Detailed description

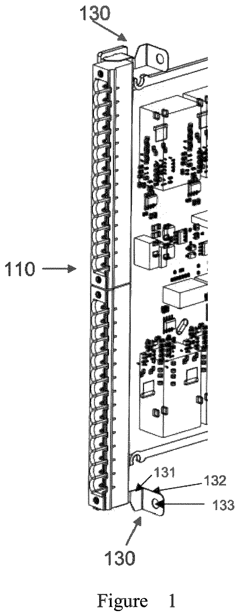

Figure 1 shows an embodiment of a pluggable electrical module of the present invention. In this embodiment, the pluggable electrical module 100 includes a PCB board 110, a housing 120, metal tabs 130, and captive screws 140.

As shown in figure 1, a portion of the metal tab 130 is welded to the PCB board 110. By the weld, the metal tab 130 forms a good conductive connection with the ground plane of the PCB board 110. The metal tab 130 includes a first bent portion 131 which is bent from the welded portion at a substantially 90 degree angle. In addition, the metal tab 130 further includes a second bent portion 132 bent rightward from the front end of the first bent portion 131 at a substantially 90 degree angle. The second bent portion 132 includes a tab through-hole 133 which is substantially in the middle of the second bent portion in the up-and-down direction. Preferably, the tab through-hole 133 is of circular shape. However, its shape can also be any other suitable shape.

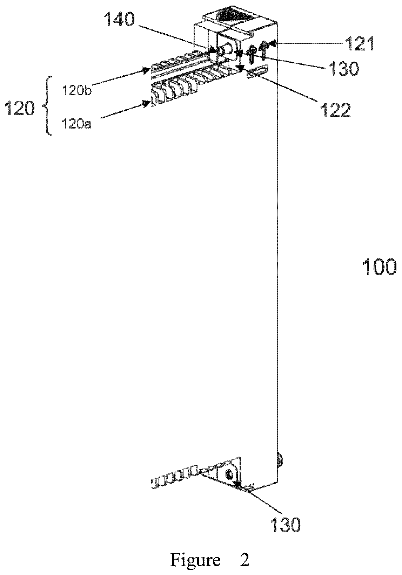

The housing 120 is composed of a first housing half 120a and a second housing half 120b that can be mated together. In order to reduce the overall weight and manufacturing cost of the pluggable electrical module 100, the housing 120 is preferably made of a plastic material. As shown in figure 2, each of the two housing halves includes two projecting portions projecting in the up-and-down direction at the rear end. The projecting portion 121 of the upper portion of the first housing half portion 120a is specifically described below. It should be noted that the structure of the projecting portion 121 may be equally applicable to the lower projecting portion of the first housing half portion 120a and the two projecting portions of the second housing half portion 120b. The front end surface 122 of the projecting portion 121 is flat. In the assembled configuration of the pluggable electrical module 100, the PCB board 110 is enclosed in the two housing halves. The first bent portion 131 of the metal tab 130 is sandwiched between the two projecting portions respectively belonging to the two housing halves, and the second bent portion 132 extends beyond the two projecting portions and may substantially rest on the front end surface 122.

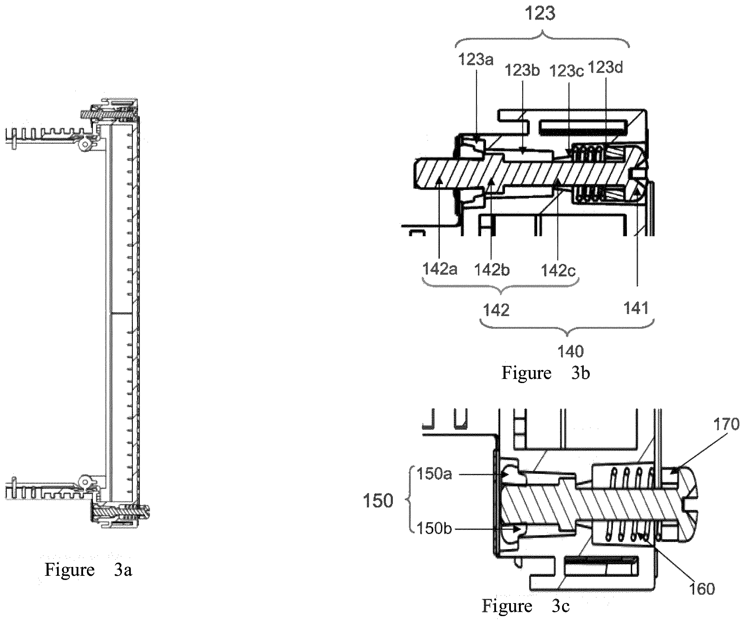

The projecting portion 121 includes a housing through-hole 123 in the front-rear direction. The longitudinal axis (i.e., along the front-rear direction) of the housing through-hole 123 is substantially perpendicular to the vertical plane bisecting the projecting portion 121 in the left-right direction and almost coincides with the longitudinal axis of the tab through-hole 133. The housing through-hole 123 includes a plurality of through-hole segments arranged in the longitudinal direction. In the particular embodiment shown in Figs. 3a-c, the housing through-hole 123 includes four through-hole segments 123a, 123b, 123c and 123d, respectively from the front end to the rear end. The through-hole segment 123c is a truncated tapered through-hole segment in which the inner diameter is tapered in the forward direction, and the inner diameter of the through-hole segment 123d is larger than the inner diameter of the tapered through-hole segment 123c at its rear end, and the inner diameter of the through-hole segment 123b is larger than the inner diameter of the tapered through-hole segment 123c at its front end.

In addition, according to the present invention, the pluggable electrical module 100 further includes captive screws 140. As shown in figure 3b, the captive screw 140 includes a screw head 141 and a screw rod portion 142. The screw rod portion 142 may comprise three parts arranged in the longitudinal direction, the first thread segment 142a, the second thread segment 142b, and the third rod segment 142c, respectively from the front end to the rear end, wherein the first thread segment 142a and the second thread segment 142b are both threaded while the third rod segment 142c may be threaded or not. The diameter of the second thread segment 142b is greater than that of the first thread segment 142a and the third rod segment 142c. Compare with the housing through-hole, the diameter of the second thread segment 142b is smaller than the inner diameter of the through-hole segments 123a, 123b and 123d and also smaller than the inner diameter of the tapered through-hole segment 123c at its rear end, but larger than the inner diameter of the tapered through-hole segment 123c at its front end. The diameter of the first thread segment 142a is smaller than the inner diameter of the tapered through-hole 123c at its front end and also smaller than the diameter of the tab through-hole 133. The diameter of the third rod portion 142c is smaller than the inner diameter of the tapered through-hole segment 123c at its front end. The diameter of the front end of the screw head portion 141 is larger than the diameter of the second screw portion 142b and also larger than the inner diameter of the tapered through-hole segment 123c at its rear end, but smaller than the inner diameter of the through-hole segment 123d. The rear end of the screw head 141 further includes a linear or cross-shaped groove that facilitates the screwing operation. In addition, when the front end surface of the second thread segment 142b is flush with the front end surface 122 of the projecting portion 121 of the housing, the rear end surface of the second thread segment 142b is completely disengaged from the tapered through-hole segment 123c, while the nut head has not yet come into contact with the rear end of the tapered through-hole segment 123c.

Optionally, the pluggable electrical module 100 further comprises a resilient washer. In the particular embodiment shown in figure 3c, the resilient washer is a rubber O-ring 150, but the shape and material of the resilient washer may also be any other shape and material suitable for use in the present invention. Preferably, the rubber O-ring 150 is composed of a first portion 150a at the front end and a second portion 150b at the rear end. The inner diameter of the two portions is the same and the inner diameter is larger than the diameter of the first thread segment 142a but smaller than the diameter of the second thread segment 142b. The outer diameter of the second portion 150b is dimensioned so that the second portion 150b can be fitted into the through-hole segment 123b. The outer diameter of the first portion 150a is larger than the outer diameter of the second portion 150b but smaller than the inner diameter of the through-hole segment 123a.

Optionally, the pluggable electrical module 100 further includes a spring 160. As shown in figure 3c, the spring 160 is inserted though by the third rod segment 142c of the rod portion 142 of the captive screw 140 and is located within the through-hole segment 123d. As shown in figure 3c, the inner diameter of the spring 160 is larger than the diameter of the second thread segment 142b but smaller than the front end diameter of the screw head portion 141. In addition, the outer diameter of the spring 160 is larger than the inner diameter of the tapered through-hole segment 123c at its rear end, but smaller than the inner diameter of the through-hole segment 123d.

Optionally, the pluggable electrical module 100 also includes a colour identification ring 170. As shown in figure 3c, the colour identification ring 170 is nested on the third rod segment 142c of the rod portion 142 of the captive screw 140. If a spring 160 is provided, the colour identification ring 170 is then located between the spring 160 and the screw head 141. The inner diameter of the colour identification ring 170 is larger than the diameter of the second thread segment 142b but smaller than the front end diameter of the screw head 141. Moreover, the outer diameter of the colour recognition ring 170 is larger than the outer diameter of the spring 160 but smaller than the inner diameter of the through-hole segment 123d.

In accordance with one embodiment of the present invention, a method of assembling the pluggable electrical module 100 is provided. The method consists in the following steps: first, the metal tab 130 is fixed to the PCB board 110, preferably by welding, so that the metal tab 130 and the ground layer of the PCB board 110 form a good conductive connection. Next, the first housing half 120a and the second housing half 120b are fitted to enclose the PCB board 110 in the fitted housing 120, making the tap through-hole 133 substantially coaxial with the housing through-hole 123. Then, the captive screw 140 is inserted into the housing through-hole 123. When the front end of the second thread segment 142b abuts against the inner diameter of the tapered through-hole segment 123c, the anti-detaching screw 140 may be pushed forward by tools, such as screwdriver, so that the thread of the second thread segment 142b taps the inner wall of the tapered through-hole segment 123c and forces the tapered through-hole segment 123c to expand. Here, the second thread segment 142b acts as a self-tapping screw. When the second thread segment 142b moves forward and completely passes beyond the tapered through-hole segment 123c, the inner wall of the tapered through-hole segment 123c is returned to the initial position under elastic force, making retreat of the second thread segment 142b impossible, thus preventing the disengagement of the captive screw 140 with the housing 120.

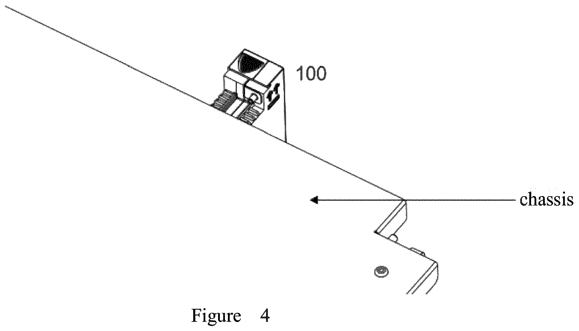

As shown in figure 4, after the pluggable electrical module 100 is assembled, the electrical module can be inserted into the chassis. A screw hole which can cooperate with a first thread segment 142a of the captive screw 140 is already formed on the chassis. By inserting the first thread segment 142a through the tab through-hole 133 and screwing into the threaded hole, the pluggable electrical module 100 is fastened to the chassis, and the front end surface of the second thread segment 142b pushes the second bent portion 132 of the metal tab 130 forward, pressing it firmly against the outer surface of the chassis, thus making the contact resistance between the chassis and the metal tab 130 as small as possible, forming a reliable high-current discharge grounding connection. In this way, the pluggable electrical module 100 according to the present invention can simultaneously form a reliable high-current discharge grounding connection while being fastened to the chassis, eliminating the cumbersome steps of installing a separate grounding cable, saving the time cost by the plug operation of the electrical module, and eliminating the risk that the PCB board is not grounded due to forgetting to install the grounding cable.

Alternatively, the resilient washer may be inserted into the through-hole 123a before the insertion of the captive screw 140. In the preferred embodiment of the resilient washer being the rubber O-ring 150, the second portion 150b of the rubber O-ring 150 may also be inserted into the through-hole segment 123b. In this way, when the pluggable electrical module 100 is fastened to the chassis, the second threaded portion 142b of the captive screw 140 will push the resilient washer, which in turn presses the second bent portion 132 of the metal tab 130 firmly against the outer surface of the chassis. The tolerances accumulated during the manufacture and assembly processes of the electrical module and the chassis can be filled by the deformation capability of the resilient washer, thus ensuring a reliable high-current discharge grounding connection between the electrical module and the chassis in any case.

Alternatively, before inserting the captive screw 140 into the through-hole 123 of the housing 120, the spring 160 and/or the colour identification ring 170 may be nested on the screw rod portion 142 of the captive screw 140. As shown in figure 3b, after the pluggable electrical module 100 is fastened to the chassis, the spring 160 can push the anti-disengagement screw 140 rearward to ensure a tight engagement between the first threaded segment 142a and the threaded hole of the chassis, so as to prevent the captive screw 140 from being loosened. The colour identification ring 170 may be used to confirm in a simple and intuitive manner whether a reliable grounding connection is formed between the electrical module and the chassis. The principle is that if the colour recognition ring 170 is still visible after the pluggable electrical module 100 is fastened to the chassis, it is determined that the metal tab 130 has not pressed against the outer surface of the chassis firmly enough, whereas if the colour recognition ring 170 has been fully pushed into the through-hole segment 123d and cannot be seen externally, it is determined that the metal tab 130 has been pressed against the outer surface of the chassis tightly.

## Claims

1. A pluggable electrical module comprises:
a printed circuit board (110);
a housing (120) for enclosing the printed circuit board (110) therein, the housing (120) includes at least one housing through-hole (123) with a plurality of through-hole segments (123a, 123b, 123c, 123d) arranged along its longitudinal direction;
a captive screw (140) comprising a screw head (141) and a screw rod (142) including a thread segment, the captive screw (140)
passes through the housing through-hole (123) in a forward direction, the captive screw (140) is used to fasten the pluggable electrical module to a chassis; and
a metal tab (130) fixed to the printed circuit board (110),
**characterized in that**
the metal tab (130) includes a tab through-hole (133) through which the captive screw (140) passes, and in the assembled configuration of the pluggable electrical module, the tab through-hole (133) and
the housing through-hole (123) are coaxial with each other;
the screw rod (142) includes at least a first thread segment (142a) and a second thread segment (142b), wherein the second thread segment (142b) has a diameter greater than that of the first thread segment (142a) and is closer to the screw head (141) than the first thread segment (142a);
at least one of the through-hole segments (123a, 123b, 123c, 123d) is a truncated tapered through-hole segment (123c) whose inner diameter tapers in the forward direction, wherein the inner diameter of the front end of the truncated tapered through-hole segment (123c) is larger than the diameter of the first thread segment (142a) but smaller than the diameter of the second thread segment (142b), and the inner diameter of the rear end of the truncated tapered through-hole segment (123c) is larger than the diameter of the
second thread segment (142b), the screw (140) being made captive by passing the second threaded segment (142b) completely through the truncated tapered through-hole segment (123c); and
when the pluggable electrical module is fastened to the chassis, the first thread segment (142a) passes through the tab through-hole (133), and the second thread segment (142b) presses the metal tab (130) tightly against the chassis.

2. The pluggable electrical module according to claim 1, **characterized in that**,
the screw rod (142) of the captive screw (140) further comprises a third rod segment (142c) provided between the second thread segment (142b) and the screw head (141), the diameter of the third rod segment (142c) is smaller than the diameter of the second thread segment (142b).

3. The pluggable electrical module according to claim 1, **characterized in that**,
the number of the through-hole segments (123a, 123b, 123c, 123d) is four.

4. The pluggable electrical module according to claim 1, **characterized in that**,
it further comprises an resilient washer having an inner diameter larger than the diameter of the first thread segment (142a) but smaller than the diameter of the second thread segment (142b), when the pluggable electrical module is fastened to the chassis, the second threaded segment (142b) will press the resilient washer, which in turn presses a portion of the metal tab (130) against outer surface of the housing (120).

5. The pluggable electrical module according to claim 4, **characterized in that**,
the resilient washer is a rubber O-ring (150).

6. The pluggable electrical module according to claim 5, **characterized in that**,
the rubber O-ring (150) comprises two portions (150a, 150b) having the same inner diameter but different outer diameters, wherein one of said two portions (150a, 150b) having a smaller outer diameter is located at the rear of the rubber O-ring (150), and is fitted into the housing through-hole (123).

7. The pluggable electrical module according to claim 1, **characterized in that**,
it further comprises a spring (160) for assisting the captive screw (140), said spring (160) being nested between the second screw segment (142b) of the captive screw (140) and the screw head (141), and being compressed when the pluggable electrical module is fastened to the chassis.

8. The pluggable electrical module according to claim 1, **characterized in that**,
it further comprises a colour identification ring (170) nested between the second thread segment (142b) and the screw head (141) of the captive screw (140).

## Patentansprüche

1. Steckbares elektrisches Modul, das umfasst:
eine gedruckte Leiterplatte (110);
ein Gehäuse (120), um die gedruckte Leiterplatte (110) darin einzuschließen, wobei das Gehäuse (120) mindestens ein Gehäusedurchgangsloch (123) mit einer Vielzahl von Durchgangslochsegmenten (123a, 123b, 123c, 123d) aufweist, die entlang seiner Längsrichtung angeordnet sind;
eine unverlierbare Schraube (140), die einen Schraubenkopf (141) und einen Schraubenschaft (142) mit einem Gewindesegment umfasst, wobei die unverlierbare Schraube (140) durch das Gehäusedurchgangsloch (123) in eine Vorwärtsrichtung hindurch verläuft, wobei die unverlierbare Schraube (140) verwendet wird, um das steckbare elektrische Modul an einem Baugruppenträger zu befestigen; und
eine an der gedruckten Leiterplatte (110) befestigte Metallzunge (130),
**dadurch gekennzeichnet, dass**
die Metallzunge (130) ein Zungendurchgangsloch (133) aufweist, durch welches die unverlierbare Schraube (140) hindurch verläuft, und dass in der zusammengebauten Konfiguration des steckbaren elektrischen Moduls das Zungendurchgangsloch (133) und das Gehäusedurchgangsloch (123) zueinander koaxial sind;
der Schraubenschaft (142) mindestens ein erstes Gewindesegment (142a) und ein zweites Gewindesegment (142b) aufweist, wobei das zweite Gewindesegment (142b) einen größeren Durchmesser als das erste Gewindesegment (142a) aufweist und sich näher bei dem Schraubenkopf (141) befindet als das erste Gewindesegment (142a);
mindestens eines der Durchgangslochsegmente (123a, 123b, 123c, 123d) ein kegelstumpfförmiges Durchgangslochsegment (123c) ist, dessen Innendurchmesser sich in die Vorwärtsrichtung verjüngt, wobei der Innendurchmesser des vorderen Endes des kegelstumpfförmigen Durchgangslochsegments (123c) größer als der Durchmesser des ersten Gewindesegments (142a), aber kleiner als der Durchmesser des zweiten Gewindesegments (142b) ist und der Innendurchmesser des hinteren Endes des kegelstumpfförmigen Durchgangslochsegments (123c) größer als der Durchmesser des zweiten Gewindesegments (142b) ist, wobei die Schraube (140) unverlierbar gemacht wird, indem das zweite Gewindesegment (142b) vollständig durch das kegelstumpfförmige Durchgangslochsegment (123c) hindurchgeschoben wird; und
wenn das steckbare elektrische Modul an dem Baugruppenträger befestigt ist, das erste Gewindesegment (142a) durch das Zungendurchgangsloch (133) hindurch verläuft und das zweite Gewindesegment (142b) die Metallzunge (130) fest gegen den Baugruppenträger drückt.

2. Steckbares elektrisches Modul nach Anspruch 1, **dadurch gekennzeichnet, dass** der Schraubenschaft (142) der unverlierbaren Schraube (140) ferner ein drittes Schaftsegment (142c) umfasst, das zwischen dem zweiten Gewindesegment (142b) und dem Schraubenkopf (141) bereitgestellt ist, wobei der Durchmesser des dritten Schaftsegments (142c) kleiner als der Durchmesser des zweiten Gewindesegments (142b) ist.

3. Steckbares elektrisches Modul nach Anspruch 1, **dadurch gekennzeichnet, dass** die Anzahl der Durchgangslochsegmente (123a, 123b, 123c, 123d) vier beträgt.

4. Steckbares elektrisches Modul nach Anspruch 1, **dadurch gekennzeichnet, dass** es ferner eine elastische Unterlegscheibe umfasst, die einen Innendurchmesser aufweist, der größer als der Durchmesser des ersten Gewindesegments (142a), aber kleiner als der Durchmesser des zweiten Gewindesegments (142b) ist, wobei, wenn das steckbare elektrische Modul an dem Baugruppenkörper befestigt ist, das zweite Gewindesegment (142b) gegen die elastische Unterlegscheibe drücken wird, welche wiederum einen Teil der Metallzunge (130) gegen eine Außenoberfläche des Gehäuses (120) drückt.

5. Steckbares elektrisches Modul nach Anspruch 4, **dadurch gekennzeichnet, dass**
die elastische Unterlegscheibe ein O-Ring (150) aus Gummi ist.

6. Steckbares elektrisches Modul nach Anspruch 5, **dadurch gekennzeichnet, dass**
der O-Ring (150) aus Gummi zwei Abschnitte (150a, 150b) mit dem gleichen Innendurchmesser aber verschiedenen Außendurchmessern umfasst, wobei einer der zwei Abschnitte (150a, 150b) mit einem kleineren Außendurchmesser an der Hinterseite des O-Rings (150) aus Gummi angeordnet ist und in das Gehäusedurchgangsloch (123) eingepasst ist.

7. Steckbares elektrisches Modul nach Anspruch 1, **dadurch gekennzeichnet, dass** es ferner eine Feder (160) zum Unterstützen der unverlierbaren Schraube (140) umfasst, wobei die Feder (160) zwischen das zweite Schraubensegment (142b) der unverlierbaren Schraube (140) und den Schraubenkopf (141) eingebaut ist und zusammengedrückt wird, wenn das steckbare elektrische Modul an dem Baugruppenträger befestigt wird.

8. Steckbares elektrisches Modul nach Anspruch 1, **dadurch gekennzeichnet, dass** es ferner einen Farbidentifikationsring (170) umfasst, der zwischen das zweite Gewindesegment (142b) und den Schraubenkopf (141) der unverlierbaren Schraube (140) eingebaut ist.

## Revendications

1. Module électrique enfichable comprenant :
une carte de circuit imprimé (110) ;
un boîtier (120) pour y enfermer la carte de circuit imprimé (110), le boîtier (120) incluant au moins un trou traversant de boîtier (123) ayant une pluralité de segments de trou traversant (123a, 123b, 123c, 123d) disposés le long de sa direction longitudinale ;
une vis captive (140) comprenant une tête de vis (141) et une tige de vis (142) incluant un segment fileté, la vis captive (140) passant à travers le trou traversant de boîtier (123) dans une direction avant, la vis captive (140) étant utilisée pour fixer le module électrique enfichable à un châssis ; et
une languette métallique (130) fixée sur la carte de circuit imprimé (110),
**caractérisé en ce que**
la languette métallique (130) inclut un trou traversant de languette (133) par lequel passe la vis captive (140) et, dans la configuration assemblée du module électrique enfichable, le trou traversant de languette (133) et le trou traversant de boîtier (123) sont coaxiaux l'un à l'autre ;
la tige de vis (142) inclut au moins un premier segment fileté (142a) et un deuxième segment fileté (142b), le deuxième segment fileté (142b) ayant un diamètre supérieur à celui du premier segment fileté (142a) et étant plus proche de la tête de vis (141) que le premier segment fileté (142a) ;
au moins l'un des segments de trou traversant (123a, 123b, 123c, 123d) est un segment de trou traversant tronconique (123c) dont le diamètre intérieur se rétrécit vers l'avant, le diamètre intérieur de l'extrémité avant du segment de trou traversant tronconique (123c) étant supérieur au diamètre du premier segment fileté (142a) mais inférieur au diamètre du deuxième segment fileté (142b), et le diamètre intérieur de l'extrémité arrière du segment de trou traversant tronconique (123c) étant supérieur au diamètre du deuxième segment fileté (142b), la vis (140) étant rendue captive en faisant passer le deuxième segment fileté (142b) complètement à travers le segment de trou traversant tronconique (123c) ; et
lorsque le module électrique enfichable est fixé au châssis, le premier segment fileté (142a) passe à travers le trou traversant de languette (133) et le deuxième segment fileté (142b) presse la languette métallique (130) fermement contre le châssis.

2. Module électrique enfichable selon la revendication 1, **caractérisé en ce que** la tige de vis (140) de la vis captive comprend en outre un troisième segment de tige (142c) prévu entre le deuxième segment fileté (142b) et la tête de vis (141), le diamètre du troisième segment de tige (142c) étant plus petit que le diamètre du deuxième segment fileté (142b).

3. Module électrique enfichable selon la revendication 1, **caractérisé en ce que** le nombre de segments de trou traversant (123a, 123b, 123c, 123d) est de quatre.

4. Module électrique enfichable selon la revendication 1, **caractérisé en ce qu'**il comprend en outre une rondelle élastique ayant un diamètre intérieur supérieur au diamètre du premier segment fileté (142a) mais inférieur au diamètre du deuxième segment fileté (142b), et lorsque le module électrique enfichable est fixé au châssis, le deuxième segment fileté (142b) presse la rondelle élastique, qui à son tour presse une partie de la languette métallique (130) contre la surface extérieure du boîtier (120).

5. Module électrique enfichable selon la revendication 4, **caractérisé en ce que** la rondelle élastique est un joint torique en caoutchouc (150).

6. Module électrique enfichable selon la revendication 5, **caractérisé en ce que** le joint torique en caoutchouc (150) comprend deux parties (150a, 150b) ayant le même diamètre intérieur mais des diamètres extérieurs différents, dans lequel l'une desdites deux parties (150a, 150b) ayant un diamètre extérieur plus petit est située à l'arrière du joint torique en caoutchouc (150) et est logée dans le trou traversant de boîtier (123).

7. Module électrique enfichable selon la revendication 1, **caractérisé en ce qu'**il comprend en outre un ressort (160) pour assister la vis captive (140), ledit ressort (160) étant niché entre le deuxième segment de vis (142b) de la vis captive (140) et la tête de vis (141), et étant comprimé lorsque le module électrique enfichable est fixé au châssis.

8. Module électrique enfichable selon la revendication 1, **caractérisé en ce qu'**il comprend en outre une bague d'identification en couleur (170) nichée entre le deuxième segment fileté (142b) et la tête de vis (141) de la vis captive (140).
